# FASCICULE DE BREVET EUROPEEN

(11) **EP 1 549 122 B1**
(45) Date de publication et mention de la délivrance du brevet: **24.12.2008**
(21) Numéro de dépôt: 04292782.2
(22) Date de dépôt: 25.11.2004
(51) Int. Cl.: H05K 5/02

(54) **Système d'aréation d'un boîtier d'appareillage électrique ou électronique**
Belüftungssystem eines Gehäuses für elektrische oder elektronische Geräte
Venting system of a housing for electrical or electronic devices

(30) Priorité: 23.12.2003 FR 0315316
(43) Date de publication de la demande: 29.06.2005
(73) Titulaire: SAGEM Défense Sécurité, 75015 Paris (FR)
(72) Inventeur: Merlet, Etienne, 78180 Montigny Le Bretonneux (FR); Besold, Jean-Eric, 91400 Saclay (FR)
(74) Mandataire: Bérogin, Francis

(56) Documents cités:
- EP-A- 1 370 125
- US-A- 5 372 543
- US-A- 5 822 186

## Description

L'invention a trait à l'extraction d'air.

Plus particulièrement, elle concerne un système d'aération d'un boîtier dans lequel est destiné à être installé un appareillage électrique ou électronique.

Les problèmes liés à ce type de boîtier se sont posés aux inventeurs dans le domaine de l'aviation.

En effet, on trouve couramment de tels boîtiers dans les aéronefs, où ils abritent des circuits électroniques de commande dont il est essentiel d'assurer une ventilation efficace. On trouve également de tels boîtiers dans certains véhicules terrestres, notamment les véhicules militaires.

Ces boîtiers comprennent généralement une enceinte dans laquelle sont disposés les circuits électroniques et présentent une paroi inférieure et une paroi supérieure toutes deux perforées pour former respectivement une entrée d'air et une sortie d'air grâce auxquelles, à l'aide d'un ventilateur placé sous le boîtier, un courant d'air permanent s'établit dans l'enceinte pour assurer le refroidissement des circuits en fonctionnement.

Ces boîtiers sont généralement stockés dans des zones de passage de techniciens de maintenance, lesquels manipulent souvent des liquides (boissons, solvants, carburants, liquides de circuits hydrauliques, etc) dont il est nécessaire d'éviter les projections sur l'appareillage.

Or les boîtiers existants ne sont absolument pas conçus pour éviter de telles projections. En effet, les perforations dont est munie la paroi supérieure laissent, lorsqu'un liquide est malencontreusement renversé, s'écouler librement celui-ci sur l'appareillage logé dans le boîtier, appareillage qu'il est alors nécessaire, au mieux de nettoyer, au pire de remplacer.

L'invention vise notamment à résoudre les inconvénients précités en proposant un système d'aération d'un boîtier, dans lequel est destiné à être installé un appareillage électrique ou électronique, qui présente une résistance accrue aux projections de liquide.

A cet effet, l'invention propose un système d'aération d'un boîtier dans lequel est destiné à être installé un appareillage électrique ou électronique, ce boîtier ayant une paroi supérieure munie d'une bouche d'aération, ce système comportant une unité d'aération destinée à être montée sur ladite paroi au droit de la bouche d'aération, ladite unité d'aération comportant une grille sous la forme d'une paroi latérale destinée à border ladite bouche d'aération, cette paroi latérale étant munie de perforations pour permettre le passage de l'air vers la bouche d'aération, ladite paroi latérale étant prolongée, du côté opposé à la bouche d'aération, par une paroi de fond pleine, sensiblement perpendiculaire à la paroi latérale et formant un bac de récupération pour une matière liquide.

Ainsi, l'air peut librement circuler au travers de la grille tandis que la paroi de fond forme un obstacle à la pénétration de liquide au sein du boîtier. Il en résulte une meilleure protection de l'appareillage qui s'y trouve contre les projections de liquide.

Suivant un mode de réalisation, cette paroi de fond est concave, sa concavité étant tournée du côté de la grille. Il en résulte une capacité de rétention accrue du réservoir formé par la paroi de fond.

La paroi de fond et la grille forment de préférence un ensemble monobloc.

Par ailleurs, le système d'aération peut comporter des moyens pour réguler le débit d'air traversant l'unité d'aération.

La grille se présente par exemple sous la forme d'une paroi cylindrique, tandis que les moyens de régulation comportent par exemple une couronne périphérique munie d'au moins une languette qui coopère avec la grille, cette couronne étant montée à rotation par rapport à la grille entre une position dite d'ouverture dans laquelle la languette se trouve au moins en partie face à une portion de la grille dépourvue de perforations pour permettre le libre passage de l'air au travers de la grille, et une position dite de fermeture dans laquelle la languette se trouve au moins en partie face à une portion perforée de la grille pour obturer partiellement le passage d'air au travers de celle-ci.

La couronne comporte de préférence une pluralité de telles languettes, uniformément réparties sur la circonférence du couvercle.

Il est ainsi possible, en tournant le couronne, de réguler précisément le débit d'air traversant l'unité d'aération.

Par ailleurs, l'unité d'aération peut se fixer au boîtier par l'intermédiaire de la grille, laquelle peut, à cet effet, être munie de pattes de fixation à la paroi du boîtier.

En outre, l'unité d'aération peut comporter un déflecteur apte à être interposé entre la grille et la paroi du boîtier, ce déflecteur comportant une paroi périphérique déflectrice sensiblement tronconique qui s'étend en direction de la paroi de fond. Ce déflecteur permet d'éviter que des projections en biais de liquide n'atteignent l'intérieur du boîtier en traversant la grille. Afin de limiter encore le risque de pénétration de liquide au sein du boîtier, le déflecteur peut présenter un masque central plein, une ouverture annulaire étant définie entre la paroi déflectrice et ce masque pour permettre le libre passage de l'air tout en limitant plus encore le risque de pénétration de liquide au sein du boîtier, même lorsque le liquide est projeté avec un angle d'incidence élevé.

Suivant un mode de réalisation, le masque se raccorde à la paroi déflectrice par des pontets radiaux, et le déflecteur peut comporter des pattes de fixation à la paroi du boîtier.

Le système d'aération qui vient d'être décrit peut en outre comporter un ventilateur destiné à être fixé à la paroi du boîtier au droit de la bouche d'aération, de l'autre côté de la paroi par rapport à l'unité d'aération, afin de créer un mouvement d'air forcé et améliorer encore les capacités de refroidissement du système d'aération.

L'invention propose également un appareil pour le refroidissement d'un appareillage électrique et électronique, qui comporte un boîtier dans lequel est destiné à être reçu ledit appareillage, le boîtier présentant une paroi supérieure dans laquelle est pratiquée une bouche d'aération, ainsi qu'un système d'aération tel que décrit ci-dessus, monté sur le boîtier au droit de la bouche d'aération.

D'autres objets et avantages de l'invention apparaîtront à la lumière de la description faite ci-après en référence aux dessins annexés dans lesquels:
- la figure 1 est une vue en perspective éclatée d'un système d'aération conforme à l'invention;
- la figure 2 est une vue en perspective du système d'aération de la figure 1, représenté assemblé ;

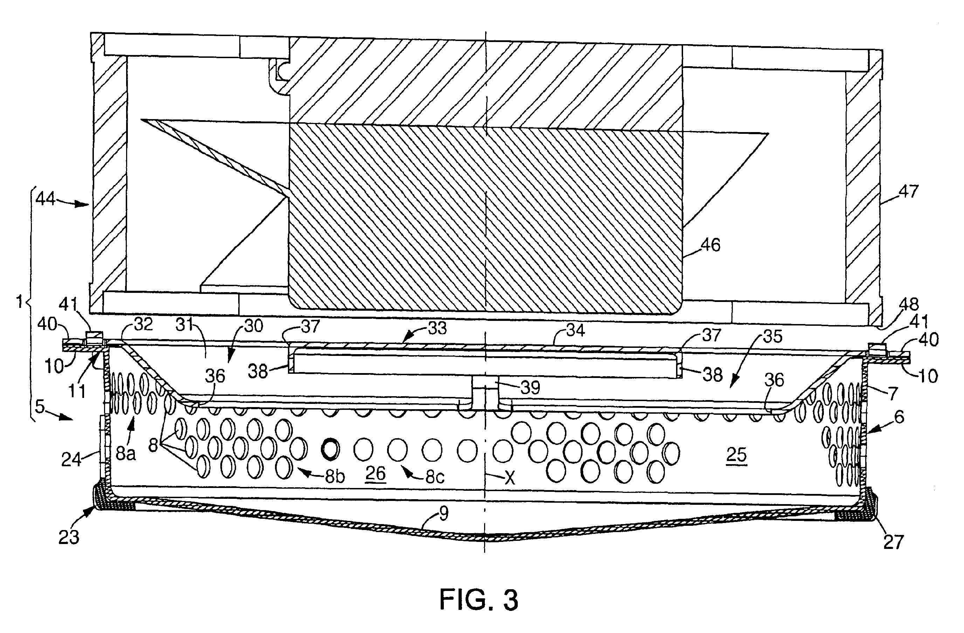

- la figure 3 est une vue d'élévation en coupe du système d'aération de la figure 2 ;
- la figure 4 est une vue en perspective en coupe montrant un système d'aération monté sur la paroi supérieure d'un boîtier destiné à contenir un appareillage électrique ou électronique ;
- la figure 5 est une vue d'élévation en coupe montrant une unité d'aération pour un système d'aération conforme à l'invention ;
- les figures 6A à 6C sont des vues en plan montrant la développée de la grille d'une unité d'aération pour un système d'aération conforme à l'invention, illustrant différentes positions de la couronne de régulation du débit d'air par rapport à la grille pour permettre une régulation du débit d'air de refroidissement.

Sur les figures est représenté un système d'aération 1 pour un boîtier 2 dans lequel est destiné à être installé un appareillage électrique ou électronique, qui peut être constitué par une pluralité de cartes portant des circuits intégrés, par exemple destinés à assurer la commande de pilotage automatique d'un avion ou d'un hélicoptère.

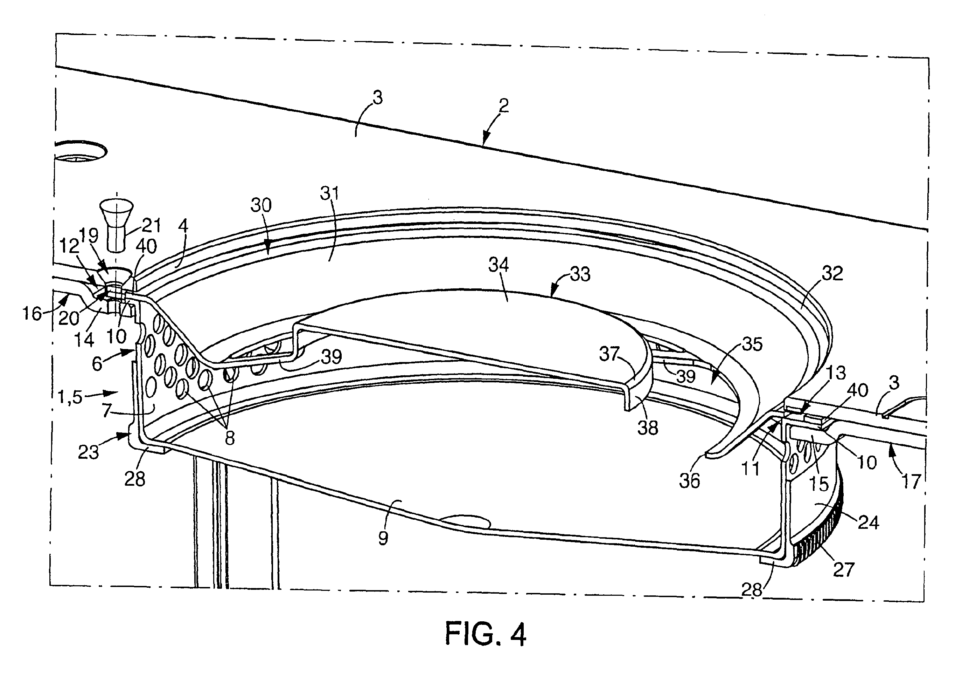

Le boîtier 2, partiellement représenté sur la figure 4, présente une paroi supérieure 3 munie d'une bouche d'aération 4 présentant en l'occurrence un contour circulaire, tout autre profil (rectangulaire, carré, ovale, etc.) pouvant être envisagé.

Bien que cela ne soit pas représenté sur les dessins, il faut imaginer qu'un tel boîtier 2 est muni, dans une autre paroi (par exemple dans une paroi inférieure opposée à la paroi supérieure 3), d'une entrée d'air (non représenté) par laquelle l'air, éventuellement pulsé par un ventilateur disposé au voisinage de cette entrée d'air, pénètre dans le boîtier pour être ensuite évacué par la bouche d'aération 4.

Ainsi, il existe dans le boîtier 2 un circuit d'air de refroidissement qui, partant de l'entrée d'air et sortant par la bouche d'aération 4, assure le refroidissement de l'appareillage, lequel a en effet tendance à s'échauffer en fonctionnement.

Comme cela est représenté sur la figure 4, le système d'aération 1 comporte une unité d'aération 5 destinée à être montée directement sur la paroi 3 au droit de la bouche d'aération 4.

Cette unité d'aération 5 comporte une pièce 6 en forme de panier ou de faisselle (cette dénomination sera retenue pour la suite de la description), destinée à laisser passer l'air tout en assurant la récupération d'éventuelles matières liquides qui pourraient s'écouler par la bouche d'aération 4 vers l'intérieur du boîtier 2.

Cette faisselle 6 comporte une paroi latérale - ou périphérique - 7, de préférence cylindrique, qui, lorsque l'unité d'aération 5 est montée sur la paroi supérieure 3 du boîtier 2 au droit de la bouche d'aération 4, entoure cette dernière.

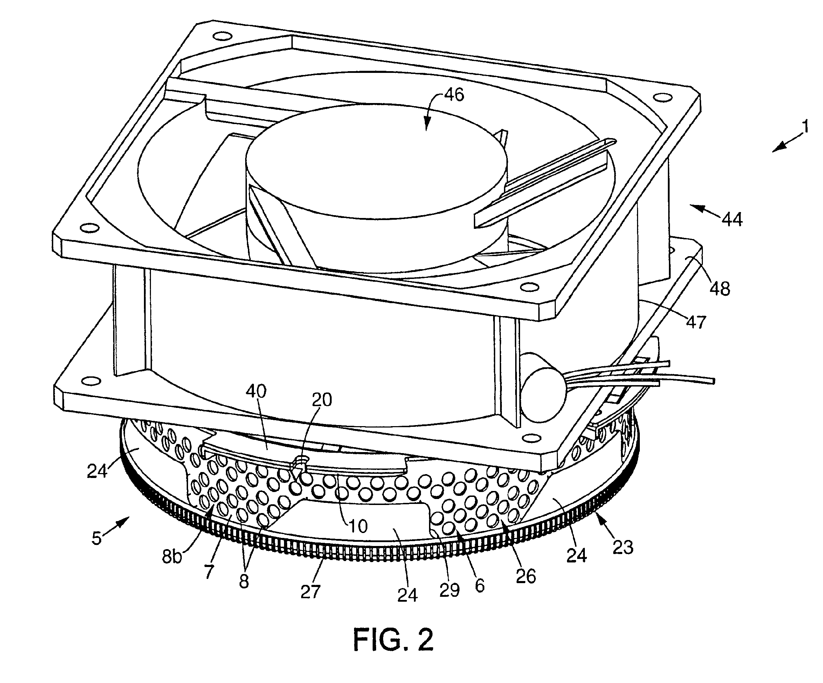

Comme cela est visible notamment sur la figure 2, la paroi périphérique 7 de la faisselle 6 présente une multitude de perforations 8 réparties sur sa circonférence, en sorte que la paroi 7 forme une grille d'aération permettant le libre passage de l'air depuis l'intérieur du boîtier 2 vers la bouche d'aération 4 (ou réciproquement).

Comme cela est visible notamment sur la figure 4, la faisselle 6 comporte en outre une paroi de fond 9 pleine (c'est-à-dire dépourvue de trous), qui, d'un seul tenant avec la grille 7, prolonge celle-ci du côté opposé à la bouche d'aération 4 au droit et à distance de laquelle elle s'étend, la faisselle 6 ayant ainsi, en section, sensiblement la forme d'un U.

Dans l'exemple représenté sur les figures, la bouche d'aération 4 ayant un contour circulaire, la faisselle 6 présente une symétrie de révolution par rapport à un axe X qui, lorsque l'unité d'aération 5 est montée sur la paroi 3 du boîtier 2, est sensiblement confondu avec l'axe X.

Dans l'exemple que nous décrivons en référence aux figures annexées, la faisselle 6 est monobloc, mais la grille 7 et la paroi de fond 9 pourraient être deux pièces distinctes fixées l'une à l'autre, sans que les capacités de la faisselle 6 s'en trouvent affectées.

Par ailleurs, suivant un mode préféré de réalisation, la faisselle 6 est réalisée dans une matière plastique moulée, ce qui présente un avantage en terme de coût et de facilité de mise en oeuvre, mais elle pourrait tout aussi bien être réalisée dans une matière métallique, par exemple en aluminium.

Dans l'hypothèse où serait recherchée une protection électromagnétique des appareillages électriques ou électroniques contenus dans le boîtier 1, la faisselle 6 devrait préférentiellement être métallique ou au moins être rendue partiellement conductrice, par exemple par métallisation de l'une au moins de ses faces, ou par intégration de charges conductrices au sein de la matière moulée, ou par tout autre procédé connu de l'homme du métier.

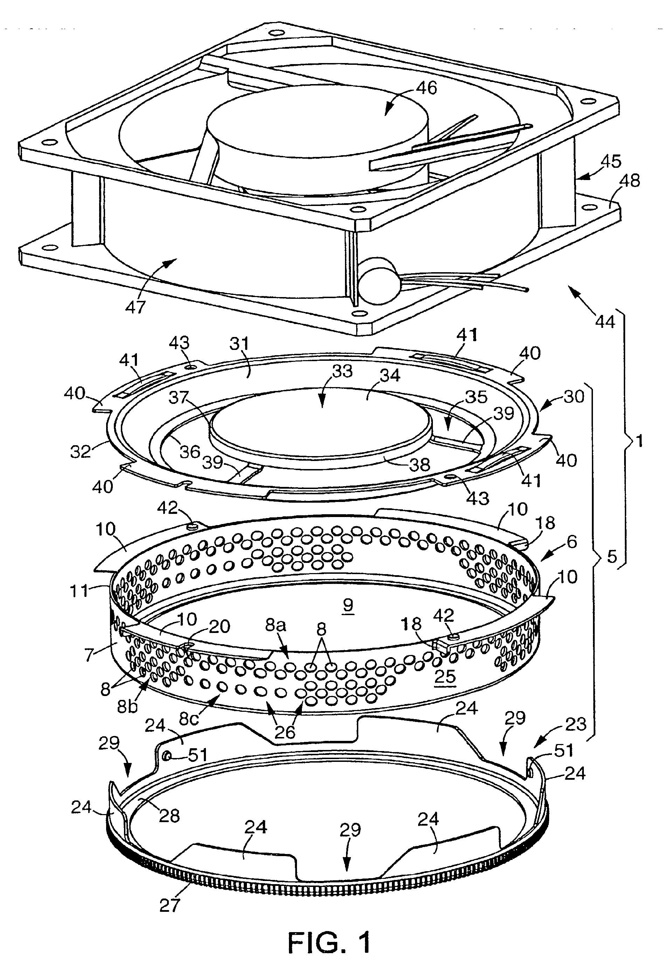

Comme cela est visible sur la figure 1, la faisselle 6 est munie de pattes de fixation 10 qui s'étendent radialement en saillie par rapport à la grille 7, à partir d'un bord supérieur 11 de celle-ci opposé à la paroi de fond 9.

Ces pattes 10 sont destinées à venir se glisser dans des rainures complémentaires 12, 13 formées entre la paroi 3 du boîtier 2 et des crochets 14, 15 formés par des plaquettes 16, 17 coudées, fixées à la paroi 3 du boîtier 2 au voisinage de la bouche d'aération 4.

Le montage de la faisselle 6 s'effectue ainsi en deux temps : premièrement, application de la faisselle 6 par l'intérieur du boîtier 2 contre la paroi 3 de celui-ci et, deuxièmement, rotation de la faisselle 6 autour de son axe X pour glisser les pattes de fixation 10 à l'intérieur des rainures 12, 13.

Comme cela est visible sur la figure 1, les pattes de fixation 10 de la faisselle 6 sont munies de retours en équerre 18 formant des butées qui, venant s'appliquer contre la tranche des plaquettes 16, 17, limitent la course en rotation de la faisselle 6, assurant ainsi que cette dernière est correctement positionnée par rapport à la paroi 3 et par rapport à la bouche 4.

Une fois la faisselle 6 correctement mise en place, elle se trouve suspendue à la paroi 3 par l'intermédiaire des crochets 14, 15. Afin d'éviter tout démontage intempestif de la faisselle 6, on peut prévoir un goupillage de celle-ci par rapport à la paroi 3. Ainsi, suivant un mode de réalisation illustré sur la figure 4, la paroi 3 est percée, au voisinage de la bouche d'aération 4, d'un trou 19 qui débouche, lorsque la faisselle 6 est correctement positionnée, au droit d'une échancrure 20 ménagée dans l'une des pattes de fixation 10. L'introduction d'une goupille 21 au travers conjointement de ce trou 19 et de l'échancrure correspondante 20 permet d'immobiliser en rotation la faisselle 6 par rapport à la paroi 3 du boîtier 2.

La paroi de fond 9 forme un bac de récupération et de rétention de toute matière liquide qui viendrait à s'écouler au travers de la bouche d'aération 4 vers l'intérieur du boîtier 2. On comprend aisément que la capacité volumique du bac de rétention ainsi formé dépend de la distance séparant la paroi de fond 9 des perforations 8 de la grille 7 les plus proches de la paroi de fond 9.

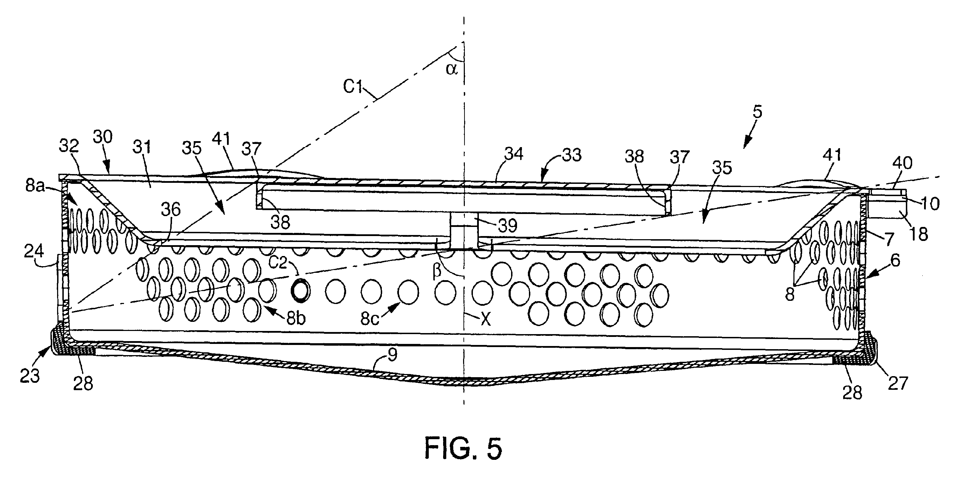

Afin de garantir une capacité volumétrique suffisante du bac de rétention ainsi formé sans toutefois devoir concentrer les perforations 8 dans la partie supérieure de la grille 7, on peut conformer en creux la paroi de fond 9, comme cela est représenté sur la figure 5. La paroi de fond 9 est ici concave, à concavité tournée vers la grille 7.

En outre, les inventeurs ont jugé opportun d'équiper l'unité d'aération 5 de moyens pour réguler le débit d'air qui la traverse.

Ainsi, suivant un mode de réalisation illustré notamment sur la figure 2, ces moyens de régulation comportent une couronne périphérique 23 munie d'au moins une languette 24 (en pratique, conformément au mode de réalisation illustré sur la figure 1, la couronne 23 comporte une pluralité de languettes 24, six en l'occurrence, uniformément réparties sur sa circonférence), qui vient s'appliquer par l'extérieur contre la grille 7.

Cette couronne 23 est montée à rotation par rapport à la grille 7 autour de l'axe X entre une position dite d'ouverture dans laquelle la languette 24 se trouve au moins en partie face à une portion 25 de la grille 7 dépourvue de perforations, de manière à permettre le libre passage de l'air au travers de la grille 7, et une position dite de fermeture dans laquelle la languette 24 se trouve au moins en partie face à une portion perforée 26 de la grille 7 pour obturer au moins partiellement le passage de l'air par rapport à celle-ci. Comme cela est visible sur les figures 1 et 2, la couronne 23 présente un bord périphérique annulaire 27 qui facilite sa préhension par un technicien chargé de modifier le débit d'air permis par l'unité d'aération 5 en tournant la couronne 23 par rapport à la grille 7.

Comme cela est clairement illustré sur les figures 4 et 5, la couronne 23 présente une collerette 28, qui, lorsque la couronne 23 est montée sur la faisselle 6 à la jonction entre la grille 7 et la paroi de fond 9, vient s'appliquer contre cette dernière.

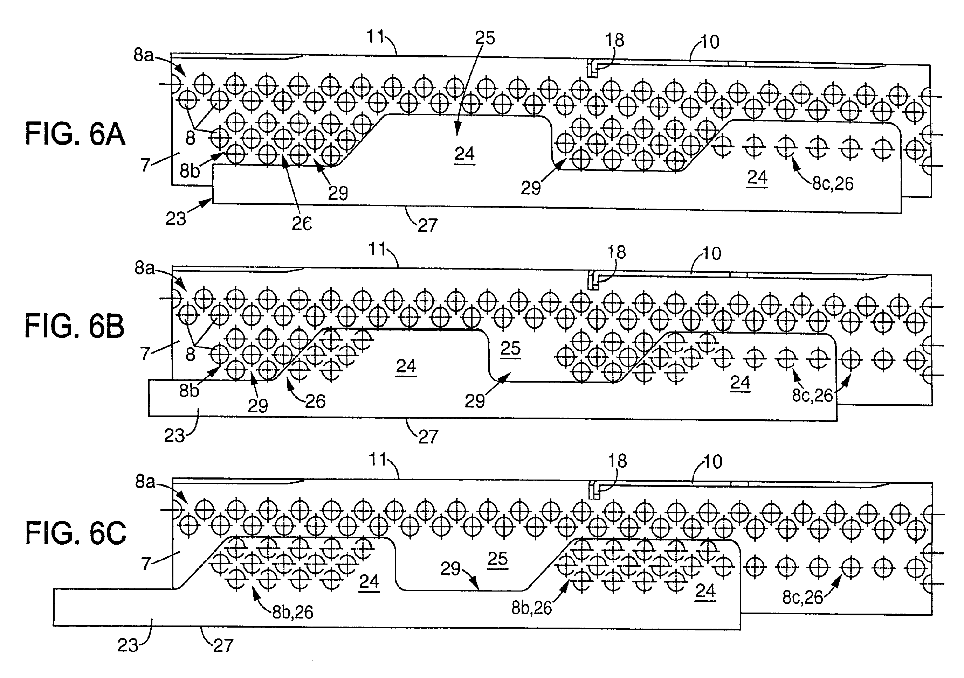

Les inventeurs ont réfléchi à la manière d'assurer une régulation efficace du débit d'air permis par l'unité d'aération 5. Comme cela est visible sur les figures 6A à 6C, qui illustrent une portion de la grille 7 et de la couronne 23, toutes deux mises à plat, la grille 7 est munie d'une rangée principale de perforations 8a qui s'étendent au voisinage du bord supérieur 11, parallèlement à celui-ci, ainsi que, du côté de cette rangée 8a opposé audit bord 11, des grappes de perforations 8b régulièrement disséminées sur la circonférence de la grille 7.

Entre certaines de ces grappes 8b sont prévues des portions 25 dépourvues de perforations, tandis qu'entre d'autres de ces grappes 8b sont prévues des rangées secondaires 8c de perforations.

La couronne 23 est représentée sur la figure 6A dans sa position d'ouverture. Dans cette position, l'une des languettes 24 se trouve en face d'une portion 25 dépourvue de perforations, tandis que la languette 24 qui lui est voisine se trouve en face d'une rangée secondaire 8c de perforations, les grappes 8b se trouvant quant à elles en face d'échancrures 29 ménagées dans la couronne 23 entre les languettes 24.

Cette position d'ouverture de la couronne 23 garantit un débit d'air correspondant au maximum des capacités de l'unité d'aération 5.

Sur la figure 6C, la couronne 23 est représentée dans sa position de fermeture. Dans cette position, chaque languette 24 se trouve en face d'une grappe 8b de perforations, le débit d'air correspond alors au minimum permis par l'unité d'aération 5.

Une position intermédiaire entre la position d'ouverture et la position de fermeture de la couronne 23 est représentée sur la figure 6B. Dans cette position, l'une des languettes 24 chevauche à la fois une grappe 8b de perforations et une portion 25 dépourvue de perforations, tandis que la languette voisine 24 chevauche une grappe 8b et une rangée secondaire 8c de perforations 8.

On comprend que dans cette position, le débit d'air permis par l'unité d'aération 5 est intermédiaire entre sa valeur minimale et sa valeur maximale.

Suivant un mode de réalisation illustré notamment sur les figures 4 et 5, l'unité d'aération 5 comporte en outre un déflecteur 30 destiné à limiter encore le risque que des projections de liquide atteignent l'intérieur du boîtier 2.

Ce déflecteur 30, interposé entre la faisselle 6 -entre la grille 7, plus exactement- et la paroi 3 du boîtier 2, comporte une paroi périphérique déflectrice 31 tronconique de révolution centrée sur un axe confondu avec l'axe X de la faisselle 6 lorsque les deux pièces 6 et 30 sont assemblées, cette paroi 31 s'étendant depuis un bord extérieur circulaire 32 du déflecteur 30 vers l'axe de révolution de celui-ci en direction de la paroi de fond 9 de la faisselle 6.

Cette paroi déflectrice 31 protège la grille 7 contre d'éventuelles projections obliques de liquide depuis l'extérieur du boîtier 2.

Cette paroi 31, qui est incurvée en direction de la paroi de fond 9, forme également une gouttière guidant vers celle-ci l'écoulement d'un liquide qui aurait atteint la bouche d'aération 5.

En outre, afin de réduire encore le risque que des projections de liquide n'atteignent la grille 7, le déflecteur 30 comporte de préférence un masque central 33 comprenant une membrane 34 pleine -c'est-à-dire dépourvue de perforations- à contour circulaire coaxial avec la paroi déflectrice 31. Le masque 33 et la paroi déflectrice 31 définissent ainsi entre eux une ouverture annulaire 35 pour permettre le passage de l'air depuis l'intérieur du boîtier 2 vers la bouche d'aération 4.

L'ouverture angulaire α du cône virtuel C1 joignant le bord interne 36 de la paroi déflectrice 31 et le bord externe 37 du masque 33 définit l'angle d'incidence maximal suivant lequel une projection oblique centrifuge (c'est-à-dire s'éloignant de l'axe X) de liquide peut atteindre la faisselle 6. L'homme du métier pourra veiller, en choisissant à dessein les dimensions respectives du masque 33 et de la paroi déflectrice 31, à ce que ce cône C1 n'intersecte pas la grille 7 ou, tout du moins, l'intersecte au-dessous des perforations 8.

En outre, afin de limiter encore le risque que des projections obliques n'atteignent la grille 7, le masque 33 peut être muni d'un rebord annulaire 38 qui s'étend perpendiculairement à la membrane 34 en direction de la paroi de fond 9.

L'ouverture angulaire β du cône virtuel C2 joignant le bord extérieur 32 du déflecteur 30 à l'extrémité du rebord 38 définit l'angle d'incidence maximal suivant lequel une projection oblique centripète (c'est-à-dire dirigée en direction de l'axe X) de liquide peut atteindre l'intérieur de la faisselle 6.

De même que précédemment, l'homme du métier pourra veiller, en choisissant les dimensions respectives de la paroi déflectrice 31, du masque 33 -notamment la hauteur de son rebord 38-, à ce que ce cône C2 n'intersecte pas la grille 7, ou l'intersecte au mieux au-dessous des perforations 8.

Comme cela est visible sur la figure 1, le masque 33 est raccordé à la paroi déflectrice 31 par des pontets de liaison 39 qui, s'étendant radialement, assurent le soutien du masque 33.

Comme cela est également représenté sur la figure 1, le déflecteur 30 comporte, comme la faisselle 6, des pattes de fixation 40 qui s'étendent radialement depuis le bord extérieur 32. Ces pattes 40 viennent se superposer aux pattes 10 de la faisselle 6 et sont introduites conjointement à ces dernières dans les rainures 12, 13.

Afin d'assurer un calage de l'unité d'aération 5 par rapport à la paroi 3 du boîtier 2, certaines au moins des pattes 40 du déflecteur 30 (trois en l'occurrence) sont munies de lamelles ressort 41 qui, venant s'appuyer contre la paroi 3, sollicitent conjointement le déflecteur 30 et la faisselle 6 en direction des crochets 14, 15.

Par ailleurs, afin d'assurer un positionnement correct du déflecteur 30 par rapport à la faisselle 6, deux au moins des pattes 10 de cette dernière sont munies de pions de positionnement 42 en saillie qui viennent se loger dans des trous 43 ménagés en regard dans deux pattes 40 correspondantes du déflecteur 30.

Suivant un mode de réalisation illustré sur les figures 1 et 2, le système d'aération 1 peut en outre comporter un ventilateur 44 destiné à être fixé à la paroi 3 du boîtier 2 au droit de la bouche d'aération 4, de l'autre côté de la paroi 3 par rapport à l'unité d'aération 5.

Ce ventilateur 44 comporte un boîtier 45 dans lequel une hélice ou une turbine 46 (selon que le ventilateur est axial ou centrifuge) est montée à rotation autour d'un axe fixe par rapport au boîtier 45, cet axe étant confondu avec l'axe X de révolution de la faisselle 6 lorsque l'ensemble du système 1 est monté sur le boîtier 2.

Le boîtier 45 du ventilateur 44 comporte une paroi cylindrique 47 dont une extrémité inférieure est conformée en platine 48, platine par laquelle le ventilateur 44 est fixé sur la paroi 3 du boîtier 2.

Ce ventilateur 44 est conformé pour évacuer l'air soit latéralement, dans le cas d'un ventilateur centrifuge, soit au-dessus du ventilateur dans le cas d'un ventilateur axial (comme cela est représenté sur les figures 1 et 2).

Il est à noter que la grille 7 ménage en son sein une cavité dans laquelle s'écoule l'air avant d'atteindre le ventilateur 44, de sorte qu'il n'est pas nécessaire, au contraire des systèmes connus, de ménager un espace supplémentaire entre la paroi supérieure 3 du boîtier 2 et le ventilateur 44, lequel peut être directement monté sur la paroi 3. Il en résulte un gain de place substantiel.

Par ailleurs, il est à noter que le masque 33 se trouve à l'aplomb de la partie centrale du ventilateur 44, et de ce fait n'obstrue en rien l'aspiration de l'air en provenance de l'intérieur du boîtier 2 par le ventilateur 44. Aussi la protection contre les projections obliques ne se fait-elle pas au détriment de l'écoulement de l'air.

Le montage du système d'aération 1 qui vient d'être décrit s'effectue comme suit.

On commence par assembler les divers composants de l'unité d'aération 5 en montant la couronne 23 et le déflecteur 30 sur la faisselle 6.

Comme cela est visible sur la figure 1, certaines des languettes 24 de la couronne 23 sont munies de pions 51 aptes à venir se loger dans des perforations 8c des zones 25 de la grille 7, assurant ainsi, d'une part le soutien de la couronne 23 et, d'autre part le maintien de celle-ci dans une position angulaire donnée par rapport à la faisselle 6, cette position étant choisie par le technicien.

Les languettes 24 présentent en outre une certaine flexibilité, de sorte que, d'une part, le montage de la couronne 23 sur la faisselle 6 s'effectue par encliquetage et, d'autre part, il n'est pas difficile, en tournant la couronne 23, de forcer les pions 51 à sortir des perforations 8 dans lesquelles ils se trouvent pour positionner différemment la couronne 23.

Le déflecteur 30 est emboîté sur la faisselle 6 en positionnant leurs pattes de fixation respectives 10, 40 au droit les unes des autres, comme cela est illustré sur la figure 1. A ce sujet, il est à noter que les pions de positionnement 42 dont est munie la faisselle 6, et leurs trous respectifs 43 prévus dans le déflecteur 30 constituent des moyens de détrompage qui rendent impossible un montage tête-bêche du déflecteur 30 sur la faisselle 6.

## Revendications

1. Système d'aération (1) d'un boîtier (2) dans lequel est destiné à être installé un appareillage électrique ou électronique, ledit boîtier ayant une paroi supérieure (3) munie d'une bouche d'aération (4), ce système étant **caractérisé en ce qu'**il comporte une unité d'aération (5) destinée à être montée sur ladite paroi supérieure (3) du boîtier (2) au droit de la bouche d'aération (4), ladite unité d'aération (5) comportant une grille (7) sous la forme d'une paroi latérale destinée à border ladite bouche d'aération (4), cette grille (7) étant munie de perforations (8) pour permettre le passage de l'air vers la bouche d'aération (4), ladite grille (7) étant prolongée, du côté opposé à la bouche d'aération (4), par une paroi de fond (9) pleine, sensiblement perpendiculaire à la grille (7) et formant un bac de récupération pour une matière liquide.

2. Système d'aération selon la revendication 1, dans lequel la paroi de fond (9) est concave, sa concavité étant tournée du côté de la grille (7).

3. Système d'aération selon la revendication 1 ou 2, dans lequel la paroi de fond (9) et la grille (7) forment un ensemble monobloc.

4. Système d'aération selon l'une des revendications 1 à 3, comportant des moyens (23) pour réguler le débit d'air traversant ladite unité d'aération (5).

5. Système d'aération selon la revendication 4, dans lequel ladite grille se présente sous la forme d'une paroi sensiblement cylindrique, et dans lequel lesdits moyens de régulation comportent une couronne (23) périphérique munie d'au moins une languette (24) qui coopère avec la grille (7), cette couronne (23) étant montée à rotation par rapport à la grille (7) entre une position dite d'ouverture dans laquelle ladite languette (24) se trouve au moins en partie face à une portion (25) de la grille (7) dépourvue de perforations pour permettre le libre passage de l'air au travers de la grille (7), et une position dite de fermeture dans laquelle la languette (24) se trouve au moins en partie face à une portion perforée (26) de la grille (7) pour obturer au moins partiellement le passage de l'air au travers de celle-ci.

6. Système d'aération selon la revendication 5, dans lequel la couronne (23) comporte une pluralité de languettes (24) uniformément réparties sur sa circonférence.

7. Système d'aération selon l'une des revendications 1 à 6, dans lequel ladite grille (7) est munie de pattes (10) de fixation à la paroi (3) du boîtier (2).

8. Système d'aération selon l'une des revendications 1 à 7, dans lequel l'unité d'aération (5) comporte un déflecteur (30) apte à être interposé entre la grille (7) et la paroi (3) du boîtier (2), ce déflecteur (30) comportant une paroi déflectrice (31) sensiblement tronconique.

9. Système d'aération selon la revendication 8, dans lequel le déflecteur (30) présente un masque (33) central plein, et dans lequel une ouverture annulaire (35) est définie entre la paroi déflectrice (31) et ledit masque (33) pour permettre le passage de l'air vers la bouche d'aération (4).

10. Système d'aération selon la revendication 9, dans lequel le masque (33) se raccorde à la paroi déflectrice (31) par des pontets radiaux (39).

11. Système d'aération selon l'une des revendications 8 à 10, dans lequel le déflecteur (30) comporte des pattes (40) de fixation à la paroi (3) du boîtier (2).

12. Système d'aération selon l'une des revendications 1 à 11, qui comporte en outre un ventilateur (44) destiné à être fixé à la paroi (3) du boîtier (2) au droit de la bouche d'aération (4), de l'autre côté de la paroi (3) par rapport à l'unité d'aération (5).

13. Appareil pour le refroidissement d'appareillage électrique ou électronique, qui comporte un boîtier (2) dans lequel est destiné à être reçu ledit appareillage, ledit boîtier (2) présentant une paroi supérieure (3) dans laquelle est pratiquée une bouche d'aération (4), cet appareil comportant en outre un système d'aération (1) selon l'une des revendications 1 à 12, monté sur le boîtier (2) au droit de ladite bouche d'aération (4).

## Claims

1. A ventilation system (1) for a box (2) for receiving electrical or electronic equipment, said box having a top wall (3) provided with a ventilator opening (4), the system being **characterized in that** it comprises a ventilator unit (5) for securing to said top wall (3) of the box (2) in register with the ventilator opening (4), said ventilator unit (5) comprising a screen (7) in the form of a side wall for placing around said ventilator opening (4), said screen (7) being provided with perforations (8) to allow air to pass towards the ventilator opening (4), said screen (7) being extended at its side remote from the ventilator opening (4) by a solid bottom wall (9) extending substantially perpendicularly to the screen (7) and forming a vessel for recovering liquid.

2. A ventilation system according to claim 1, in which the bottom wall (9) is concave, its concave side facing towards the screen (7).

3. A ventilation system according to claim 1 or claim 2, in which the bottom wall (9) and the screen (7) form a one-piece unit.

4. A ventilation system according to any one of claims 1 to 3, including control means (23) for controlling the flow rate of air passing through said ventilator unit (5).

5. A ventilation system according to claim 4, in which said screen is in the form of a substantially cylindrical wall, and in which said control means comprise a peripheral ring (23) provided with at least one tongue (24) that co-operates with the screen (7), the ring (23) being mounted to turn relative to the screen (7) between an "open" position in which said tongue (24) overlies at least in part a portion (25) of the screen (7) that has no perforations so as to allow air to pass freely through the screen (7), and a "closed" position in which the tongue (24) overlies at least in part a perforated portion (26) of the screen (7) to shut off at least a fraction of the passage for air through the screen.

6. A ventilation system according to claim 5, in which the ring (23) has a plurality of tongues (24) uniformly distributed around its circumference.

7. A ventilation system according to any one of claims 1 to 6, in which said screen (7) is provided with fixing tabs (10) for fixing to the wall (3) of the box (2).

8. A ventilation system according to any one of claims 1 to 7, in which the ventilator unit (5) includes a deflector (30) suitable for being interposed between the screen (7) and the wall (3) of the box (2), the deflector (30) comprising a substantially frustoconical deflector wall (31).

9. A ventilation system according to claim 8, in which the deflector (30) presents a solid central mask (33), and in which an annular opening (35) is defined between the deflector wall (31) and said mask (33) to allow air to pass towards the ventilator opening (4).

10. A ventilation system according to claim 9, in which the mask (33) is connected to the deflector wall (31) by radial bridges (39).

11. A ventilation system according to any one of claims 8 to 10, in which the deflector (30) has fixing tabs (40) for fixing to the wall (3) of the box (2).

12. A ventilation system according to any one of claims 1 to 11, further comprising a fan (44) for fixing to the wall (3) of the box (2) in register with the ventilator opening (4), on the side of the wall (3) that is opposite from the side where the ventilator (5) unit is located.

13. Apparatus for cooling electrical or electronic equipment, the apparatus comprising a box (2) for receiving said equipment, said box (2) presenting a top wall (3) having a ventilator opening (4) formed therein, said apparatus further comprising a ventilation system (1) according to any one of claims 1 to 12, secured to the box (2) in register with said ventilator opening (4).

## Patentansprüche

1. Belüftungssystem (1) eines Gehäuses (2), das zur Einrichtung eines elektrischen oder elektronischen Geräts bestimmt ist, wobei dieses Gehäuses eine Oberwand (3) aufweist, die mit einer Luftdusche (4) versehen Ist, und wobei dieses System **dadurch gekennzeichnet ist, dass** es eine Belüftungseinheit zur Montage auf dieser Oberwand (3) des Gehäuses (2) umfasst, wobei die Belüftungseinheit der Luftdusche (4) gegenüber liegt, und diese Belüftungseinheit (5) ein Gitter (7) In der Form einer Seltenwand zur Umrandung dieser Luftdusche (4) aufweist, wobei dieses Gitter (7) mit Perforlerungen (8) zur Gewährleistung des Luftdurchzugs zur Luftdusche (4) ausgestattet Ist und das Gitter (7) auf der dieser Luftdusche (4) gegenüber liegenden Seite durch eine Bodenvollwand (9) verlängert ist, die nahezu senkrecht zum Gitter (7) angeordnet ist und ein Auffangbecken für einen Flüssigstoff ausbildet.

2. Belüftungssystem nach Anspruch 1, bei dem die Bodenwand (9) konkav ist und ihre Konkavität zur Seite des Gitters (7) gedreht ist.

3. Belüftungssystem nach Anspruch 1 oder 2, bei dem die Bodenwand (9) und das Gitter (7) einen Monoblocksatz ausbilden.

4. Belüftungssystem nach einem der Ansprüche 1 bis 3, das Mittel (23) zur Regulierung der Luftleitung umfasst, die diese Belüftungseinheit (5) durchströmt.

5. Belüftungssystem nach Anspruch 4, bei dem das Gitter In der Form einer nahezu zylindrischen Wand ausgebildet wird und die genannten Regulierungsmlttel eine Umfangskrone (23) aufnehmen, die mit zumindest einer Lasche (24) versehen Ist, welche mit dem Gitter (7) zusammen wirkt, wobei diese Krone (23) in Rotation im Verhältnis zum Gitter (7) zwischen einer so genannten Öffnungsstellung, bei der die Lasche (24) sich zumindest teilweise gegenüber einem Abschnitt (25) des Gitters (7) befindet, das ohne Perforierungen versehen Ist, um den freien Luftdurchzug durch das Gitter (7) zu ermöglichen, und einer so genannten Schließstellung, bei der die Lasche (24) sich zumindest teilweise gegenüber einem perforierten Abschnitt (26) des Gitters (7) befindet, um den Luftdurchzug durch dasselbige zumindest teilweise abzudichten, montiert Ist.

6. Belüftungssystem nach Anspruch 5, bei dem die Krone (23) eine Vielzahl von Laschen (24) aufweist, die einheitlich auf dem Umfang verteilt sind.

7. Belüftungssystem nach einem der Ansprüche 1 bis 6, bei dem das genannte Gitter (7) mit Befestigungsklauen (10) zur Befestigung an der Wand (3) des Gehäuses (2) ausgestattet ist.

8. Belüftungssystem nach einem der Ansprüche 1 bis 7, bei dem die Belüftungseinheit (5) einen Ableiter (30) aufweist, der geeignet ist, zwischen Gitter (7) und Wand (3) des Gehäuses (2) eingeschoben zu werden, wobei dieser Ableiter (30) eine nahezu konische Ableitungswand (31) aufweist.

9. Belüftungssystem nach Anspruch 8, bei dem der Ableiter (30) eine zentrale Vollmaske (33) aufweist und eine ringförmige Öffnung (35) zwischen der Ableltungswand (31) und der genannten Maske (33) ausgeführt wird, um den Luftdurchzug zur Luftdusche (4) zu ermöglichen.

10. Belüftungssystem nach Anspruch 9, bei dem die Maske (33) mit der Ableitungswand (31) durch Radialtunnel (39) verbunden ist.

11. Belüftungssystem nach einem der Ansprüche 8 bis 10, bei dem der Ablelter (30) Befestigungsklauen (40) zur Befestigung an der Wand (3) des Gehäuses (2) aufweist.

12. Belüftungssystem nach einem der Ansprüche 1 bis 11, das darüber hinaus einen Lüfter (44) zur Befestigung an der Wand (3) des Gehäuses (2), der Luftdusche (4) gegenüber, auf der anderen Seite der Wand (3) in Bezug auf die Belüftungseinheit (5) umfasst.

13. Gerät zur Kühlung eines elektrischen oder elektronischen Geräts, das ein Gehäuse (2) zur Aufnahme dieses Geräts umfasst, wobei das genannte Gehäuse (2) eine Oberwand (3) aufweist, in der eine Luftdusche (4) ausgeführt wird, und dieses Gerät darüber hinaus ein Belüftungssystem (1) nach einem der Ansprüche 1 bis 12 aufweist, das auf das Gehäuse (2) der genannten Luftdusche (4) gegenüber montiert wird.
